Europäisches Patentamt

(19) European Patent Office   (11) Publication number: **0 018 192**

Office européen des brevets   **B1**

(12) **EUROPEAN PATENT SPECIFICATION**

(45) Date of publication of patent specification: **21.11.85**   (51) Int. Cl.⁴: **G 11 C 17/06**

(21) Application number: **80301191.5**

(22) Date of filing: **15.04.80**

(54) **Bipolar programmable read only memory device including address circuits.**

(30) Priority: **23.04.79 JP 50036/79**

(43) Date of publication of application:
**29.10.80 Bulletin 80/22**

(45) Publication of the grant of the patent:
**21.11.85 Bulletin 85/47**

(84) Designated Contracting States:
**DE FR GB NL**

(56) References cited:
**CH-A- 455 878**
**DE-A-2 844 955**
**FR-A-2 041 248**
**FR-A-2 373 124**
**US-A- 390 980**
**US-A-3 641 516**
**US-A-3 721 964**
**US-A-3 909 805**
**US-A-3 971 058**

The file contains technical information
submitted after the application was filed and
not included in this specification

(73) Proprietor: **FUJITSU LIMITED**
**1015, Kamikodanaka Nakahara-ku**
**Kawasaki-shi Kanagawa 211 (JP)**

(72) Inventor: **Fukushima, Toshitaka**
**1604-442 Shiomidai**
**Isogo-ku Yokohama-shi Kanagawa (JP)**
Inventor: **Koyama, Kazumi**
**3-17-7 Wakabadai**
**Shiroyama-cho Tsukui-gun Kanagawa (JP)**
Inventor: **Ueno, Kouiji**
**1360 Shukugawara**
**Tama-ku Kawasaki-shi Kanagawa (JP)**
Inventor: **Kawabata, Yuichi**
**708, Kashimada**
**Saiwai-ku Kawasaki-shi Kanagawa (JP)**
Inventor: **Miyamura, Tamio**
**1381 Ida**
**Nakahara-ku Kawasaki-shi Kanagawa (JP)**

(74) Representative: **Rackham, Stephen Neil et al**
**GILL JENNINGS & EVERY 53-64 Chancery Lane**
**London WC2A 1HN (GB)**

Courier Press, Leamington Spa, England.

(56) References cited:
US-A-4 014 007
US-A-4 048 626
US-A-4 094 012

IEEE PROCEEDINGS ON RELIABILITY PHYSICS,
2-4 April 1974, Las Vegas US BARNES et al.:
"Reliability Assessment of a Semiconductor
Memory by Design Analysis, pages 74-81
IEEE JOURNAL OF SOLID-STATE CIRCUITS,
vol. SC12, no. 5, October 1977 New York US
MÜLLER et al.: "An 8192-Bit EAROM
Employing a One-Transistor Cell with Floating
Gate", pages 507-514
ELECTRONIC EQUIPMENT NEWS, vol. 14, no.
11, March 1973 London GB SNYDER:
"Microprogramming with P/ROM-S" pages 51-
54
IBM TECHNICAL DISCLOSURE BULLETIN, vol.
17, no. 3, August 1974, Armonk, US WILLIAMS:
"High-Speed RAM with Simultaneous
Read/Write Operation", pages 933-934
IBM TECHNICAL DISCLOSURE BULLETIN, vol.
21, no. 1 June 1978 Armonk US RADCLIFFE:
"Fusable Diode Array Circuits", pages 105-108
IEEE I. Solid State Circuits, Vol. 7, No. 5,
October 1972, p. 357-363
IEEE INTERNATIONAL SOLID-STATE CIRCUITS
CONFERENCE18 February 1977 New York US
SCHROEDER et al "A 1024-Bit Fused-Link
CMOS PROM", Digest of Technical Papers,
pages 190-191

## Description

The present invention relates to a programmable read-only memory device, and more particularly to a bipolar semiconductor programmable read-only memory device which includes bit address decoder circuits, and which is used in electronic equipment such as electronic computers.

In general, a programmable read-only memory (PROM) device comprises a number of memory cells located at crossing points of a matrix which is formed by a cross structure of a number of bit lines and a number of word lines. Each of the memory cells is, for example, a shorted-junction type or a fuse-blown type and is connected between one of the word lines and one of the bit lines. The device also comprises address buffers or address inverters which amplify and invert input address signals, decoders which decode the address signals from the address buffers, multiplexers or encoders which encode information from the memory cells, output buffers which amplify output signals from the multiplexers, and program circuits or writing-in circuits which initially write-in information to a selected memory cell.

In the past, several types of decoders have been used as the word address decoder for decoding word address signals in order to select one of the word lines and as the bit address decoders for decoding bit address signals in order to select one of the bit lines. Usually one bit address decoder has been connected to the multiplexer and used for reading-out information from a selected memory cell, and another bit address decoder has been connected to the program circuit and used for writing-in information into a selected memory cell. These two bit address decoders are supplied with the same bit address signals and each of the bit address decoders includes a plurality of AND gates each consisting of a plurality of diodes. Therefore, the sink current, which flows from the program circuit or multiplexer through the diodes to the bit address inverters, is relatively large. Consequently, it is necessary to use output power transistors having a large driving capability in the output stage of the bit address inverters, and it is also necessary to use different inverters to drive the two decoders.

To obtain a large driving capability in the prior devices the size of the output power transistors of the bit address inverters must be large, so that the packing density of the device is reduced and the switching speed of the bit address inverters is low. Moreover, the prior device needs different bit address inverters for driving the two decoders, which also reduces the packing density of the device.

According to this invention a programmable read-only memory device of the kind set out in the first part of claim 1 is characterised by at least one of the first and second bit address decoders being formed by a plurality of AND gates each consisting of a plurality of vertical PNP type transistors having their bases connected to the bit address buffer to receive the address signals, having their collectors commonly connected to the ground, and having their emitters commonly connected to an output terminal. The use of vertical PNP devices in an AND gate is known per se from IEEE Journal of Solid-State Circuits, Vol. 7, No. 5, October 1972, pages 357—363. However that document is primarily concerned with the fabrication of NPN and vertical PNP devices by a triple diffusion process for use in an LSI correlator, and does not concern PROMs.

An advantage of the present invention is that a high switching speed of the bit address inverters is obtained by decreasing the current which flows into the output stage of the bit address inverters when writing-in or reading-out information.

Another advantage of the present invention is that the circuitry of the bit address inverters may be simplified by using a common bit address inverter for driving the decoders in both the reading-out and writing-in staes.

Two particular embodiments of a programmable read-only memory device in accordance with this invention will now be described and contrasted with earlier embodiments with reference to the accompanying drawings; in which:—

Figure 1 is a block diagram of a conventional bipolar 4K-bit PROM device;

Figure 2 is a circuit diagram of part of a conventional PROM device;

Figure 3 is a circuit diagram of part of a device in accordance with a first embodiment of the present invention;

Figure 4 is a circuit diagram of a bit address inverter used with the present invention;

Figure 5 is a circuit diagram of a word address decoder/driver circuit used in the present invention;

Figure 6 is a circuit diagram of a program circuit unit used in the present invention;

Figure 7 is a circuit diagram of a multiplexer unit and an output buffer unit used in the present invention; and

Figure 8 is a block diagram illustrating a part of a device in accordance with a second embodiment of the present invention.

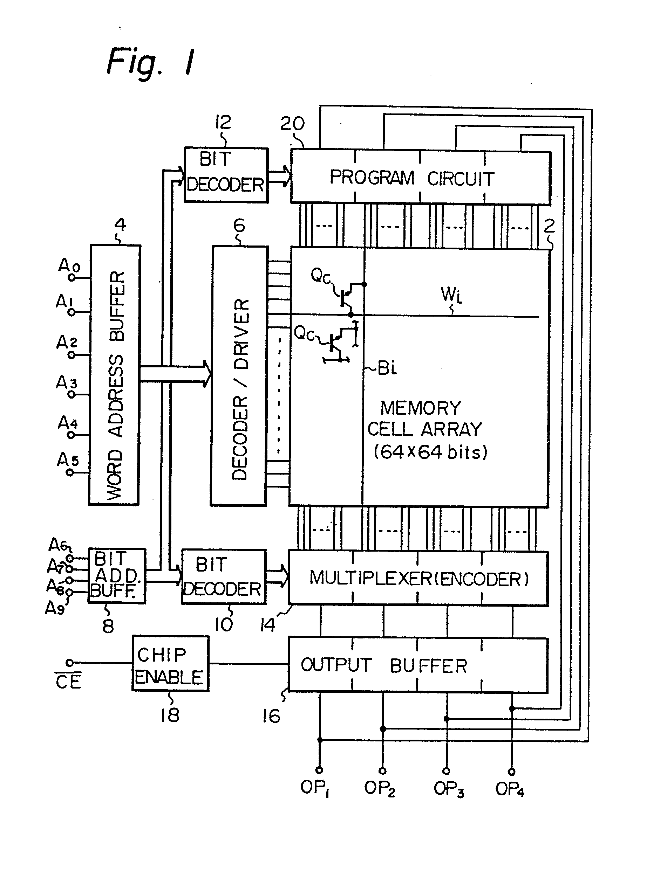

Figure 1 is a block diagram illustrating a conventional bipolar 4K-bit PROM device, which comprises a memory cell array 2 composed of 4906 memory cells disposed in a matrix of 64 rows and 64 columns. Each of the memory cells is composed, for example, of an open-base type transistor which is equivalent to a series connection of two diodes of opposite polarity. Writing-in information into this memory cell is effected by bringing one of the PN junctions to a short-circuit status due to the supply of a large writing-in current. A word address buffer or word address inverters 4 amplify and invert input word address signals $A_0$ through $A_5$, and the word address decoder/driver 6 decodes the word address signals from the word address buffer 4 and applies the decoded word address signals to the memory cell array 2. The bit address buffer or bit address inverters 8 amplify and invert input bit address signals $A_6$ through $A_9$, and apply the output bit address signals to the bit address decoder 10 connected to the multiplexer 14 and the bit address decoder 12 connected to the program circuit 20. The decoder 10 decodes the output bit address signals from the bit address buffer 8 and applies the decoded bit address signals (bit selection signals for reading-out) to the multiplexer 14. The multiplexer 14 reads out information from the memory cells connected between the word line selected by the above-mentioned word address decoder/driver 6 and the bit lines selected by the bit address decoder 10. The output buffer 16 amplifies the reading out signals from the multiplexer 14, and applies the amplified reading out signals to output terminals $OP_1$ through $OP_4$. The output buffer 16 is enabled by the chip enable circuit 18 which receives an input chip enable signal. The decoder 12 decodes the ouptut bit address signals from the bit address buffer 8 and applies the decoded bit address signals (bit address signals for writing-in) to the program circuit 20. The program circuit 20 writes in information to the memory cells which is connected between the word line selected by the word address decoder/driver 6 and the bit lines selected by the bit address decoder 12.

The reading out of information from the above-mentioned PROM is effected by applying the 6 bits word address signals $A_0$ through $A_5$ to the word address buffer 4, the 4 bits bit address signals $A_6$ through $A_9$ to the bit address buffer 8, and a "low" level voltage to the chip enable circuit 18. 4 bits information from the selected memory cells appears at the output terminals $OP_1$ through $OP_4$, through the multiplexer 14 and the output buffer 16.

The writing-in of information to the PROM is effected by applying the 6 bits word address signals $A_0$ through $A_5$ to the word address buffer 4, the 4 bits bit address signals $A_6$ through $A_9$ to the bit address buffer 8, and the "high" level voltage to the chip enable circuit 18. The 4 bits data signals to be written-in are applied to the output terminals $OP_1$ through $OP_4$ of the PROM device. In this case, the output buffer 16 is cut off from the output terminals $OP_1$ through $OP_4$ due to the "high" level signal to the chip enable circuit 18. Therefore, the data signals to be written-in pass from the output terminal to the program circuit 20, and the writing-in of information corresponding to the data signals to the selected memory cells is effected.

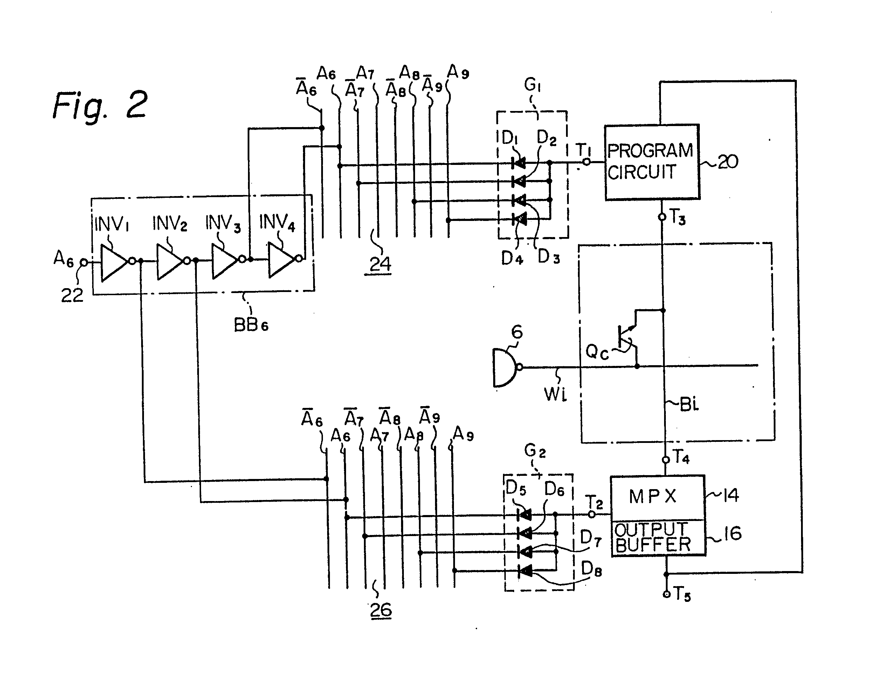

Fig. 2 is a parocal block diagram illustrating a conventional PROM device having bit address decoders consisting of a plurality of diode AND gates. In Fig. 2, the bit address buffer unit $BB_6$ consists of a series correction of four inverters $INV_1$ through $INV_4$. An input terminal 22 of the inverter $INV_1$ serves as the input terminal of the bit address buffer $BB_6$. Output terminals of the inverters $INV_1$ and $INV_2$ are connected to the corresponding leads of the address signal lines 26 in the reading-out stage, and output terminals of the inverters $INV_3$ and $INV_4$ are connected to the corresponding leads of the address signal lines 24 in the writing-in stage. In addition to the bit address buffer unit $BB_6$, there are three other bit address buffer units $BB_7$ through $BB_9$ connected to the bit address signal lines 24 and 26, which are not shown in the drawing. Bit address decoder units or AND gates $G_1$ and $G_2$ are connected respectively to the address signal lines 24 and 26. In addition to the AND gates $G_1$ and $G_2$, there are fifteen other AND gates connected to the address signal lines 24 and fifteen other AND gates connected to the address signal lines 26, which are not shown in the drawing. Output terminals $T_1$ and $T_2$ of the AND gates $G_1$ and $G_2$ are connected to the program circuit or the writing-in circuit 20 and to the multiplexer or the reading-out circuit 14 respectively. A terminal $T_3$ of the program circuit 20 is connected to one end of a bit line $B_i$, to which the emitter of the memory cell transistor $Q_c$ is connected. The collector of the memory cell transistor $Q_c$ is connected to a word line $W_i$ which is connected to an output terminal of the word address decoder/driver circuit 6. The other end of the bit line $B_i$ is connected to a bit line terminal $T_4$ of the multiplexer 14. An output terminal $T_5$ of the output buffer 16 is connected to a writing-in current input terminal of the program circuit 20.

Operation of the circuit illustrated in Fig. 2 will now be explained. The input bit address signal, for example, $A_6$ is applied to the address signal input terminal 22, and the address signals $A_6$ and $\overline{A}_6$ are produced by the inverters $INV_1$ through $INV_4$ and supplied to the address signal lines 24 and 26. The input bit address signals consist of four bit signals $A_6$ through $A_9$. Therefore, the other three bit address signals $A_7$, $A_8$, $A_9$ are applied to the other inverter stagss, which are not shown in the drawing, and the address signals $A_7$, $\overline{A}_7$, $A_8$, $\overline{A}_8$, $A_9$, $\overline{A}_9$ are produced and supplied to the corresponding lines of the address signal lines 24 and 26.

The address signals from the address signal lines 24 and 26 are respectively supplied to the writing-in circuit 20 and the reading-out circuit 14 through the AND gates (decoder units) $G_1$ and $G_2$ and decoder output terminals $T_1$ and $T_2$.

The AND gates $G_1$ and $G_2$ consist of four diodes $D_1$ through $D_4$ and $D_5$ through $D_8$, respectively, and each anode electrode of the diodes $D_1$ through $D_4$ is connected commonly to the decoder output terminal $T_1$, and each anode electrode of the diodes $D_5$ through $D_8$ is connected commonly to the decoder output terminal $T_2$. Each cathode electrode of the diodes $D_1$ through $D_4$ is connected, for example, to the leads $A_6$, $\overline{A}_7$, $A_8$ and $A_9$, respectively, of the address signal lines 24, and each cathode electrode of the diodes $D_5$ through $D_8$ is connected to the identical leads $A_6$, $\overline{A}_7$, $A_8$ and $A_9$, respectively, of the address signal lines 26.

If more than one of the address signals $A_6$, $\overline{A}_7$, $A_8$, $A_9$ applied respectively to the diodes $D_1$, $D_2$, $D_3$, $D_4$, which compose the AND gate $G_1$, is "low",

the output signal from the AND gate $G_1$ goes "low" so that the writing-in circuit 20 is not enabled. If all of the address signals $A_6$, $\overline{A}_7$, $A_8$, $A_9$ are "high", the output signal of the AND gate $G_1$ becomes high and current does not flow from the writing-in circuit 20 to the AND gate $G_1$ so that the writing-in circuit is enabled.

The writing-in circuit 20 which is enabled by the address signals $A_6$, $\overline{A}_7$, $A_8$, $A_9$ passes the writing-in current supplied from the output terminal $T_5$ through the terminal $T_3$ to the bit line $B_i$ corresponding to the address signals.

The emitter-base junction of the memory cell transistor $Q_c$, which is connected between the above-mentioned bit line $B_i$ and the word line selected by the word address decoder/driver circuit 6, is short circuited due to the supply of the writing-in current; thereby the writing-in of information is performed.

With regard to the reading-out of information, when all of the address signals $A_6$, $\overline{A}_7$, $A_8$, $A_9$ are "high", the output of the AND gate $G_2$ becomes "high", and the AND gate $G_2$ does not absorb current from the reading-out circuit 14, so that the reading-out circuit 14 is enabled and the reading-out of information from the corresponding bit line $B_i$ is performed.

If the memory cell transistor $Q_c$ connected between the bit line $B_i$ and the word line $W_i$ selected by the word address decoder/driver circuit 6 is short-circuited at its emitter-base junction, the reading-out current flows from the terminal $T_4$ through the bit line $B_i$, the cell transistor $Q_c$ and the word line $W_i$ to the word address decoder/driver circuit 6. If the memory cell transistor $Q_c$ is not short circuited, the reading-out current does not flow.

The reading-out circuit 14 detects the information from the memory cell $Q_c$ by detecting whether the above-mentioned reading-out current flows or not, and outputs the detected information from the output terminal $T_5$.

In this case, the selected word line $W_i$ is pulled down to "low" by the word address decoder/driver circuit 6; thereby the writing-in current or reading-out current can be absorbed by the circuit 6.

However, since each of the AND gates $G_1$ and $G_2$ of the circuit illustrated in Fig. 1 consists of diodes, the current which passes from the writing-in circuit 20 or the reading-out circuit 14 to the output stages of the bit address inverters $INV_1$ through $INV_4$ becomes relatively large, so that it is necessary to use transistors having a large current driving capability for the output transistors of the inverters $INV_1$ through $INV_4$.

In order to gain a large current driving capability, the big size transistors must be used in the output stage of the bit address inverters, so that the packing density of the PROM device is decreased and the operation speed of the inverters becomes low due to the increase of parasitic capacitance.

In the above-mentioned PROM device, the current flowing from the writing-in circuit 20 to the output stage of the inverters is several times as large as the current flowing from the reading-out circuit 14 to the output stage of the inverters. Therefore, the address signals supplied to the writing-in stage the address signals supplied to the reading-out stage are produced by the different inverters.

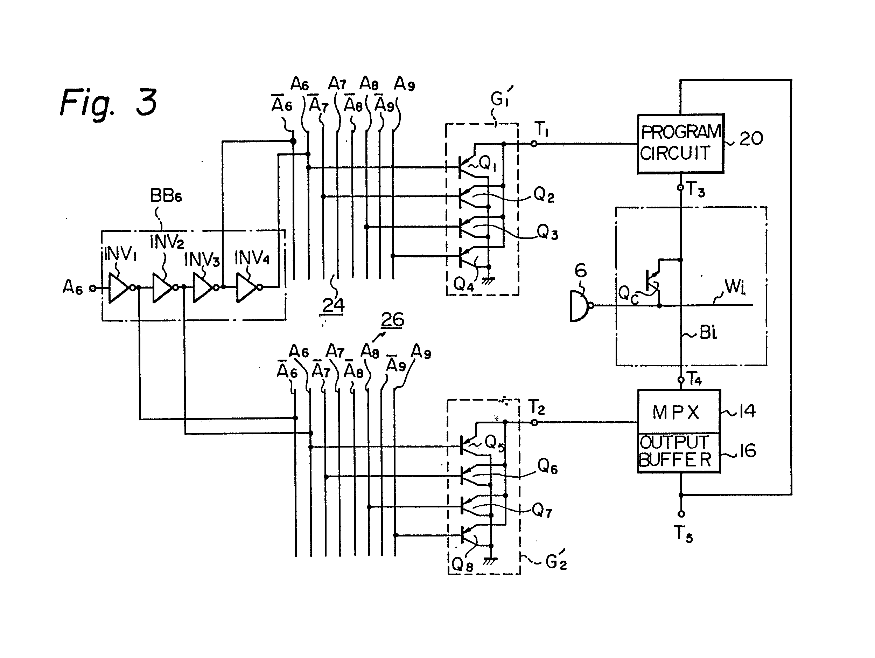

With reference to Fig. 3, an embodiment of the present invention will now be described. A circuit shown in Fig. 3 includes improved bit address decoder units $G_1{}'$ and $G_2{}'$ which replace the decoder units $G_1$ and $G_2$ shown in Fig. 2. Each decoder units $G_1{}'$ or $G_2{}'$ consists of four vertical PNP type transistors $Q_1$ through $Q_4$ or $Q_5$ through $Q_8$ instead of the diodes $D_1$ through $D_4$ of the decoder $G_1$ or $D_5$ through $D_8$ of the decoder $G_2$ included in the circuit of Fig. 2. Each base electrode of the transistors $Q_1$ through $Q_4$ or $Q_5$ through $Q_8$ is connected to the address signal lines 24 or 26, each collector electrode is commonly connected to the ground, and each emitter electrode is commonly connected to the decoder output terminal $T_1$ or $T_2$. The other part of the circuit of Fig. 3 is the same as that of the circuit illustrated in Fig. 2, and the description thereof is omitted herein.

Operation of the improved decoder unit will now be described. When at least one of the address signals $A_6$, $\overline{A}_7$, $A_8$, $A_9$ from the address signal line 24 or 26 is "low", at least one of the transistors $Q_1$ through $Q_4$ or $Q_5$ through $Q_8$ turns on, and current I flows from the decoder output terminal $T_1$ or $T_2$ to the emitter electrode of one or more of the turned on transistors. Assuming that only one PNP transistor $Q_1$ is turned on, the above-mentioned current I passes from the emitter electrode of the transistor $Q_1$ to the base electrode and the collector electrode. In this case, almost all of the current I passes through the collector electrode to the ground, and the base current $I(1-\alpha)$ which is determined by the current amplification factor $\alpha$ is very small. For example, if $\alpha=0.98$, then the base current is equal to $I/50$. Therefore, the current passing from the address signal lines 24 and 26 to the output stage of the bit address inverters $INV_1$ through $INV_4$ is extremely decreased, so that the size of each output transistor of the inverters can be decreased and a high operation speed of the inverters can be attained.

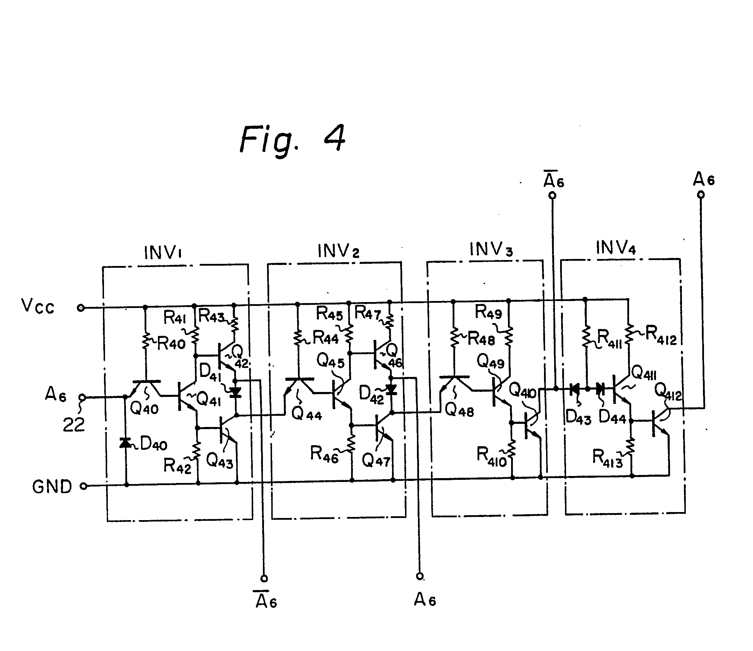

Fig. 4 illustrates a detailed circuit of the bit address buffer $BB_6$ which is a series of connections of four inverters $INV_1$ through $INV_4$. In Fig. 4, the input terminal 22 of the bit address buffer is connected to the emitter electrode of NPN type transistor $Q_{40}$ which is connected to the ground through the diode $D_{40}$. The base electrode of the transistor $Q_{40}$ is connected to a positive voltage source $V_{cc}$ through resistor $R_{40}$, and the collector electrode of the transistor $Q_{40}$ is connected to the base electrode of NPN type transistor $Q_{41}$. The collector electrode of the transistor $Q_{41}$ is connected to the base electrode of NPN type transistor $Q_{42}$ and to the voltage source $V_{cc}$ through resistor $R_{41}$. The emitter

electrode of the transistor $Q_{41}$ is connected to the base electrode of NPN type transistor $Q_{43}$ and to the ground through resistor $R_{42}$. The collector electrode of the transistor $Q_{42}$ is connected to the voltage source through resistor $R_{43}$. The emitter electrode of the transistor $Q_{42}$ is connected to output terminal of the first inverter $INV_1$ and to the collector electrode of the transistor $Q_{43}$ through diode $D_{41}$. The collector electrode of the transistor $Q_{43}$ is connected to an input terminal of the second inverter $INV_2$ or the emitter electrode of NPN type transistor $Q_{44}$. The structure of the second inverter circuit $INV_2$ is the same as that of the first inverter $INV_1$ except that the second inverter $INV_2$ does not contain a diode corresponding to the diode $D_{40}$ of the first inverter. The third inverter $INV_3$ consists of three NPN type transistors $Q_{48}$ through $Q_{410}$ and four resistors $R_{48}$ through $R_{410}$. The emitter electrode of the transistor $Q_{48}$ is connected to the collector electrode of transistor $Q_{47}$. The base electrode of the transistor $Q_{48}$ is connected to the voltage source $V_{cc}$ through the resistor $R_{48}$. The collector electrode of the transistor $Q_{48}$ is connected to the base electrode of the transistor $Q_{49}$. The collector electrode of the transistor $Q_{49}$ is connected to the voltage source $V_{cc}$ through the resistor $R_{49}$. The emitter electrode of the transistor $Q_{49}$ is connected to the base electrode of the transistor $Q_{410}$ and to the ground through the resistor $R_{410}$. The collector electrode of the transistor $Q_{410}$ constitutes an output terminal of the third inverter $INV_3$. The emitter electrode of the transistor $Q_{410}$ is connected to the ground. The fourth inverter $INV_4$ consists of two NPN type transistors $Q_{411}$ and $Q_{412}$, two diodes $D_{43}$, $D_{44}$ and three resistors $R_{411}$ through $R_{413}$. The cathode electrode of the diode $D_{43}$ constitutes an input terminal of the fourth inverter $INV_4$, and is connected to the collector electrode of the transistor $Q_{410}$. The anode electrodes of the diodes $D_{43}$, $D_{44}$ are connected to each other and to the voltage source $V_{cc}$ through resistor $R_{411}$. The cathode electrode of the diode $D_{44}$ is connected to the base electrode of the transistor $Q_{411}$ whose collector electrode is connected to the voltage source $V_{cc}$ through the resistor $R_{412}$. The emitter electrode of the transistor $Q_{411}$ is connected to the base electrode of the transistor $Q_{412}$ and to the ground through the resistor $R_{413}$. The emitter electrode of the transistor $Q_{412}$ is connected to the ground, and the collector electrode of the transistor $Q_{412}$ constitutes an output terminal of the bit address buffer.

Operation of the circuit in Fig. 4 will now be described. Assume that a "low" voltage is applied to the input terminal 22, in which condition the transistor $Q_{40}$ turns on and the collector voltage of the transistor $Q_{40}$ becomes "low", thereby turning off the transistor $Q_{41}$. When the transistor $Q_{41}$ so turns off, no current flows from the collector to the emitter of the transistor $Q_{41}$. Therefore, no current flows through the resistor $R_{43}$, and the emitter voltage of the transistor $Q_{41}$ becomes "low" so that the transistor $Q_{43}$ turns off. In this condition, current flows from the voltage source $V_{cc}$ through the resistor $R_{41}$ to the base electrode of the transistor $Q_{42}$, and the transistor $Q_{42}$ turns on, so that the emitter electrode of the transistor $Q_{42}$ or the output terminal of the first inverter $INV_1$ becomes "high". If a "high" voltage is applied to the input terminal 22, no current flows from the voltage source $V_{cc}$ through the resistor $R_{40}$ to the emitter electrode of the transistor $Q_{40}$, so that the transistor $Q_{40}$ turns off, and current flows from the voltage source $V_{cc}$ through the resistor $R_{40}$ and the base-collector junction of the transistor $Q_{40}$ to the base electrode of the transistor $Q_{41}$. Consequently, the transistor $Q_{41}$ turns on, and current flows from the voltage source $V_{cc}$ through the resistor $R_{41}$, collector-emitter current path and the resistor $R_{42}$ to the ground. Therefore, the voltage of the emitter electrode of the transistor $Q_{41}$ becomes higher than the forward biased voltage drop of the base-emitter junction of the transistor $Q_{43}$, and the transistor $Q_{43}$ turns on. When the transistor $Q_{43}$ so turns on, the collector voltage of the transistor $Q_{43}$ becomes "low" and current flows from the output terminal through the diode $D_{41}$ to the collector electrode of the transistor $Q_{43}$. In this condition, the emitter voltage of the transistor $Q_{42}$ is the sum of the forward voltage (about 0.8 volt) of the diode $D_{41}$ and the collector-emitter saturation voltage (about 0.2 volt), and the base voltage of the transistor $Q_{42}$ is the sum of the collector-emitter saturation voltage (about 0.2 volt) of the transistor $Q_{41}$ and the forward voltage of the base-emitter junction of the transistor $Q_{43}$ (about 0.8 volt). Therefore, the base voltage and the emitter voltage of the transistor $Q_{42}$ are substantially the same as each other, so that the transistor $Q_{42}$ turns off. The diode $D_{40}$ is used for absorbing the undershoot current through the input terminal 22 in order to protect the inverter circuit $INV_1$.

Operation of the second inverter $INV_2$ is the same as that of the first inverter $INV_1$ and the explanation thereof is omitted herein.

The third inverter $INV_3$ operates as follows. Assume that the emitter voltage of the transistor $Q_{48}$ is "low", in which condition the transistor $Q_{48}$ is turned on and the transistor $Q_{49}$ is turned off. Therefore, the emitter voltage is the same as that of the ground and the transistor $Q_{410}$ is turned off so that the collector of the transistor $Q_{410}$ or the output of the third inverter $INV_3$ becomes "high". If the emitter voltage of the transistor $Q_{48}$ is "high", the transistor $Q_{48}$ is turned off, and the base current of the transistor $Q_{49}$ flows from the voltage source $V_{cc}$ through the resistor $R_{48}$ and the base-collector junction of the transistor $Q_{48}$, so that the transistor $Q_{49}$ is turned on. In response to the turn on of the transistor $Q_{49}$, the transistor $Q_{410}$ turns on and outputs the low level signal from the collector electrode.

The forth inverter $INV_4$ operates as follows. Assume that a "low" level signal is applied to the cathode of the diode $D_{43}$, in which condition the current flows from the voltage source $V_{cc}$ through the resistor $R_{411}$ and the diode $D_{43}$. Therefore, the

voltage of the common connection point of the anode electrode of the diodes $D_{43}$, $D_{44}$ and one terminal of the resistor $R_{411}$ is pulled down to "low", so that the transistor $Q_{411}$ turns off. Consequently, the transistor $Q_{412}$ turns off and outputs a "high" level signal from the collector thereof. If a "high" level signal is applied to the cathode of the diode $D_{43}$, current flows from the voltage source $V_{cc}$ through the resistor $R_{411}$ and the diode $D_{44}$ to the base electrode of the transistor $Q_{411}$, so that the transistor $Q_{411}$ turns on. Therefore, current flows from the voltage source $V_{cc}$ through the resistor $R_{412}$, the collector-emitter junction of the transistor $Q_{411}$ and the resistor $R_{413}$ to the ground, and the emitter voltage of the transistor $Q_{411}$ becomes high. Consequently, the transistor $Q_{412}$ turns on and outputs a low level signal from the collector electrode thereof.

It should be noted that the third inverter $INV_3$ and the fourth inverter $INV_4$ do not contain output transistors corresponding to the transistors $Q_{42}$ of the first inverter $INV_1$, and input circuit of the fourth inverter $INV_4$ is composed of the diodes $D_{43}$, $D_{44}$ and the resistor $R_{411}$. This is because it is necessary to protect the inverters $INV_3$ and $INV_4$ from breaking down when the high voltage writing-in signal is applied to the output terminals of the inverters $INV_3$, $INV_4$ from the program circuit 20.

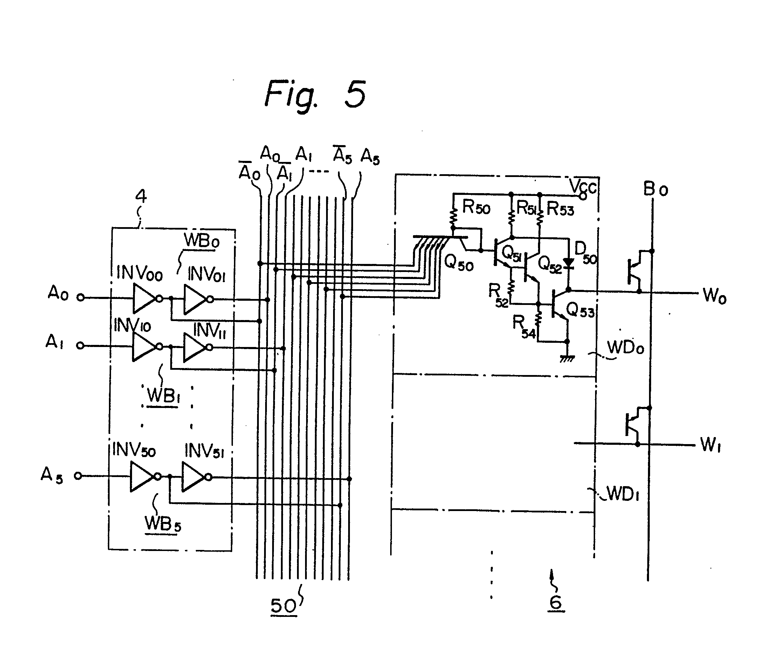

Fig. 5 is a circuit diagram illustrating the word address decoder/driver circuit. In Fig. 5, the word address buffer 4 consists of six word address buffer units $WB_0$ through $WB_5$, each of which consists of a series connection of two inverters, $INV_{00}$ and $INV_{01}$ through $INV_{50}$ and $INV_{51}$. Output terminals of the inverters $INV_{00}$, $INV_{01}$ through $INV_{50}$, $INV_{51}$ are connected to the corresponding leads of word address signal lines 50. The word address decoder/driver circuit 6 consists of 64 word address deoder/driver units $WD_0$ through $WD_{63}$ whose output terminals are connected to the corresponding word lines $W_0$ through $W_{63}$ of the memory cell array. The decoder/driver unit, for example $WD_0$, consists of a multi-emitter transistor $Q_{50}$, three NPN type transistors $Q_{51}$, $Q_{52}$, $Q_{53}$, a diode $D_{50}$ connected between collectors of the transistors $Q_{51}$ and $Q_{53}$, and five resistors $R_{50}$ through $R_{54}$. Emitters of the multi-emitter transistor $Q_{50}$ are selectively connected to the leads of the word address signal lines 50. For example, in the word address decoder/driver unit $WD_0$ whose output is connected to the word line $W_0$, the emitters of the transistor $Q_{50}$ are connected to the leads $\overline{A}_0$, $\overline{A}_1$, $\overline{A}_2$, $\overline{A}_3$, $\overline{A}_4$, $\overline{A}_5$, respectively.

Operation of the decoder/driver unit, for example $WD_0$, will now be described. Assume that the input word address signals $A_0$ through $A_5$ are all "low", in which condition the voltage level of the address signal leads $\overline{A}_0$, $\overline{A}_1$, $\overline{A}_2$, $\overline{A}_3$, $\overline{A}_4$, $\overline{A}_5$ are all "high" and the multi-emitter transistor $Q_{50}$ turns off. Therefore, current flows from the positive voltage source $V_{cc}$ through the resistor $R_{50}$ to the base of the transistor $Q_{51}$ so that the transistor $Q_{51}$ turns on. In response to the turning on of the transistor $Q_{51}$, the transistors $Q_{52}$ and $Q_{53}$ turn on, and the word line $W_0$ is pulled down to a "low" voltage level, which means the selection of the word line $W_0$.

The diode $D_{50}$ is used to decrease the base current of the transistors $Q_{51}$ through $Q_{53}$ and sustain the transistor $Q_{51}$ in an unsaturated condition in the reading-out mode in order to gain a high operation speed. The diode $D_{50}$ is cut off in the writing-in mode, because the writing-in current of a high voltage is supplied from the writing-in circuit through the selected bit line and the selected memory cell to the word line $W_0$. In the reading-out mode, the diode $D_{50}$ turns on and the base current of the transistor $Q_{51}$ flows separately to the emitter and the collector of the transistor $Q_{51}$. Therefore, the base current of the transistor $Q_{52}$ decreases and also the base current of the transistor $Q_{53}$ decreases, so that high switching speed of the transistor $Q_{53}$ is attained.

In the condition that at least one of the address signal leads $\overline{A}_0$, $\overline{A}_1$, $\overline{A}_2$, $\overline{A}_3$, $\overline{A}_4$, $\overline{A}_5$ is "low", the multi-emitter transistor $Q_{50}$ turns on and the collector voltage of the transistor $Q_{50}$ becomes low, so that the transistor $Q_{51}$, and therefore the transistors $Q_{52}$, $Q_{53}$, turns off. Therefore, the voltage of the collector of the transistor $Q_{53}$ connected to the word line $W_0$ goes "high", which means that the word line $W_0$ is not selected.

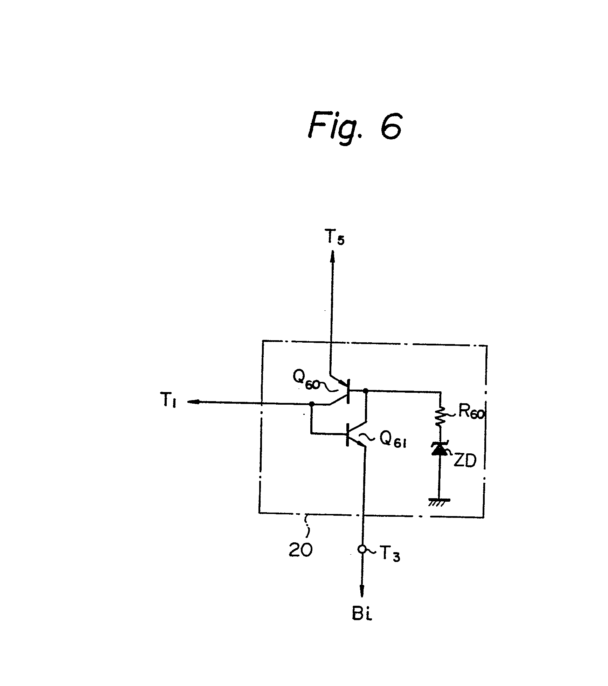

Fig. 6 illustrates the writing-in circuit unit or the program circuit unit for one bit line. In the 4K PROM device, 64 writing-in circuit units are used. The writing-in circuit unit in Fig. 6 consists of a PNP type transistor $Q_{60}$, an NPN type transistor $Q_{61}$ and a series connection of a resistor $R_{60}$ and a zener diode ZD. The collector electrode of the transistor $Q_{60}$ is connected to the output terminal $T_1$ of the bit address decoder $G_1'$ of Fig. 3 and to the base electrode of the transistor $Q_{61}$. The emitter electrode of the transistor $Q_{60}$ is connected to the output terminal $T_5$ of the output buffer 16 of Fig. 3. The base electrode of the transistor $Q_{60}$ is connected to collector electrode of the transistor $Q_{61}$ and to the series connection of the resistor $R_{60}$ and the zener diode ZD which has, for example, 20 zener voltages. The emitter electrode of the transistor $Q_{61}$ is connected to the terminal $T_3$ connected to a bit line $B_i$.

Operation of the circuit of Fig. 6 will now be described. Assume that a high voltage writing-in current of a constant current, for example 25 V—120 mA, is supplied from the output terminal $T_5$ to the emitter electrode of the transistor $Q_{60}$, in which condition a base current flows from the base electrode of the transistor $Q_{60}$ to the series connection of the resistor $R_{60}$ and the zener diode ZD, and the PNP type transistor $Q_{60}$ turns on. In this state, if the voltage level of the output terminal $T_1$ of the decoder $G_1'$ is "high" (selected condition), current flows from the collector electrode of the transistor $Q_{60}$ to the base electrode of the transistor $Q_{61}$, so that the transistor $Q_{61}$ turns on.

When transistors $Q_{60}$ and $Q_{61}$ so turn on, the writing-in current passes from the output terminal

$T_5$ through the transistors $Q_{60}$ and $Q_{61}$ and the terminal $T_3$ to the selected bit line $B_i$.

In the circuit of Fig. 6, the series connection of the resistor $R_{60}$ and the zener diode ZD constitutes a voltage control circuit which causes transistor $Q_{60}$ to turn off in the reading out mode, so that no current flows from the output terminal $T_5$ through the writing-in circuit.

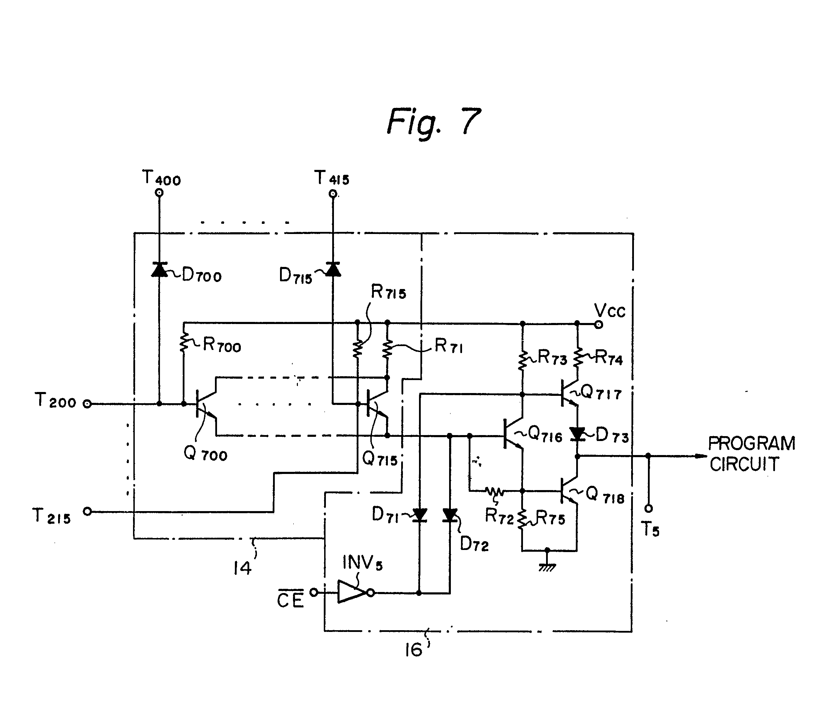

Fig. 7 illustrates the multiplexer unit and the output buffer unit. In Fig. 7, input terminals $T_{200}$ through $T_{215}$ of the multiplexer unit or the reading-out circuit unit are connected respectively to the base electrodes of 16 NPN transistors $Q_{700}$ through $Q_{715}$, the collector electrodes of which are connected commonly to the voltage source $V_{cc}$ through resistor $R_{71}$, and emitter electrodes of which are connected commonly to the base electrode of NPN transistor $Q_{716}$. Each base electrode of the transistors $Q_{700}$ through $Q_{715}$ is connected to the anode electrode of each of diodes $D_{700}$ through $D_{715}$, each cathode electrode of the diodes $D_{700}$ through $D_{715}$ is connected to each of the bit line terminals $T_{400}$ through $T_{415}$, respectively, which are connected to the bit lines of the memory cell array. Each base electrode of the transistors $Q_{700}$ through $Q_{715}$ is connected commonly to the voltage source $V_{cc}$ through registers $R_{700}$ through $R_{715}$, respectively. The collector electrode of the transistor $Q_{716}$ is connected to the base electrode of NPN transistor $Q_{717}$ and to the voltage source $V_{cc}$ through resistor $R_{73}$. The emitter electrode of the transistor $Q_{716}$ is connected to the base electrode of NPN transistor $Q_{718}$ and to the ground through resistor $R_{75}$. The base electrode and the emitter electrode of the transistor $Q_{716}$ are connected to each other through register $R_{72}$. The collector electrode of the transistor $Q_{717}$ is connected to the voltage source $V_{cc}$ through resistor $R_{74}$. The collector electrode of the transistor $Q_{718}$ is connected to the output terminal $T_5$ and to the emitter electrode of the transistor $Q_{717}$ through diode $D_{73}$. The emitter electrode of the transistor $Q_{718}$ is connected to the ground. The output terminal $T_5$ is also connected to current input terminal of the writing-in circuit 20 of Fig. 3. The base electrodes of the transistors $Q_{716}$ and $Q_{717}$ are commonly connected to an output terminal of inverter $INV_5$ through diodes $D_{71}$ and $D_{72}$ respectively. In the 4K bits PROM device, four multiplexer units and four output buffer units are used, and a fourth of them is shown in Fig. 7.

Operation of the circuit of Fig. 7 will now be described. Assume that the level of the input terminal $T_{200}$ which is connected to the output terminal of the bit address decoder is "high", and the level of the bit line terminal $T_{400}$ is "high", which means that the memory cell transistor $Q_c$ connected between the selected word line and the bit line, which is connected to the terminal $T_{400}$, is not short-circuited. In this condition, the base electrode of the transistor $Q_{700}$ becomes "high", the transistor $Q_{700}$ turns on, and the transistor $Q_{716}$ turns on. In response to the turn on of the transistor $Q_{716}$, the transistor $Q_{718}$ turns on and

the transistor $Q_{717}$ turns off; thereby the level of the output terminal $T_5$ becomes "low".

If the selected memory cell $Q_c$ is short-circuitred at its emitter-base junction, the level of the base electrode of the transistor $Q_{700}$ is "low", and the transistor $Q_{700}$ turns off. In this case, other transistors $Q_{700}$ through $Q_{715}$, which are connected parallel to the transistor $Q_{700}$, are turned off because the other input terminals $T_{201}$ through $T_{215}$ are pulled down to a "low" level by non-selected bit address decoders. Therefore, the transistor $Q_{716}$ turns off, the transistor $Q_{718}$ turns off, and the transistor $Q_{717}$ turns on, so that the level of the output terminal $T_5$ goes "high".

In the above, the operation of the reading-out circuit in the reading-out mode was described. In the writing-in mode, the chip enable signal $\overline{CE}$ is caused to become "high", and the output level of the inverter $INV_5$ goes "low"; thereby, the transistors $Q_{716}$, $Q_{717}$, $Q_{718}$ are all turned off. In such a state, the writing-in current of a high voltage is supplied to the output terminal $T_5$ and the writing-in operation is effect as described with reference to Fig. 6. However, the transistors $Q_{717}$, $Q_{718}$ are not broken down because these transistors are in a cut-off state.

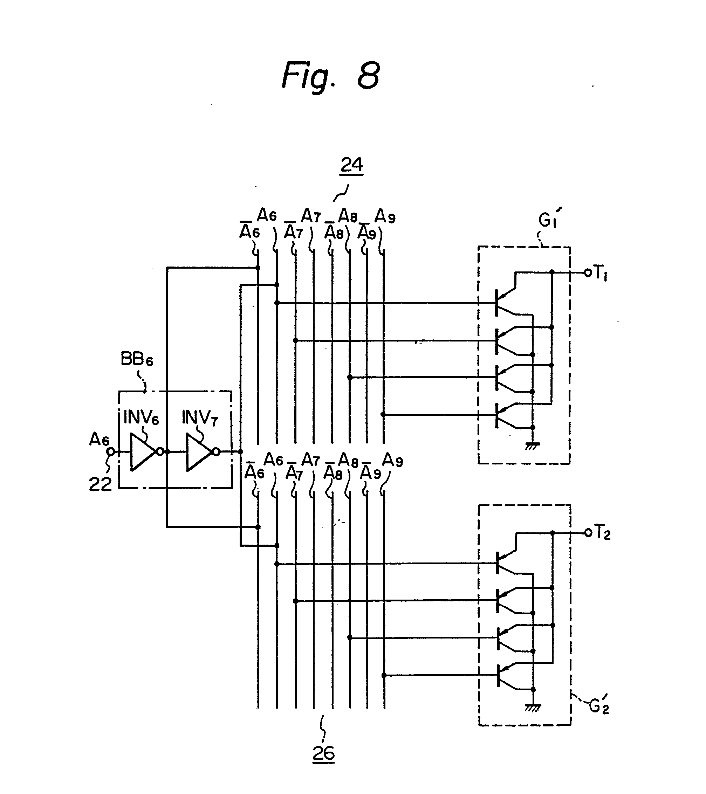

Fig. 8 illustrates another embodiment of the present invention. In Fig. 8, the bit address buffer unit $BB_6$ is composed of two inverters $INV_6$ and $INV_7$ connected in series, the output terminals of which are connected to the address signal lines 24 of the writing-in stage and the address signal lines 26 of the reading-out stage. The other circuits are the same as the circuits explained with reference to Fig. 3. In the prior art PROM device illustrated in Fig. 2, the address signals to the writing-in stage and the address signals to the reading-out stage are supplied from the different inverters in order not to decrease the operating speed of the reading-out stage. However, in the embodiment of the present invention, it is possible to omit two inverters and to supply the bit address signals to the writing-in stage and the reading-out stage from the common inverters, as shown in Fig. 8, so that the bit address buffer circuits can be greatly simplified and the packing density of the PROM device can be increased. This is because the current, which flows from the program circuit 20 through the bit address decoder 12 to the bit address inverters, can be very small according to the present invention.

It is preferable to adapt the present invention to the PROM device, including Schottky TTL gates, which can be formed without the doping of gold to the substrate of the device. In such PROM device, the PNP type transistors of the bit address decoders can be formed as so-called "vertical PNP type transistors".

## Claims

1. A bipolar programmable read-only memory device having a number of memory cells $(Q_c)$ which are located at crossing points of a number of word lines $(W_i)$ and a number of bit lines $(B_i)$,

each of the memory cells consisting of an open base type transistor ($Q_c$) connected between one of the number of bit lines ($B_i$) and one of the number of word lines ($W_i$), cells being selected by word address signals ($A_0$ to $A_5$) and bit address signals ($A_6$ to $A_9$) applied to the device, the device comprising a word address buffer (4) for amplifying the word address signals, a word address decoder (6) for decoding the word address signals from the word address buffer, one or mmre bit address buffers (8) for amplifying the bit address signals, a first bit address decoder (12) for decoding the bit address signals from the bit address buffer for writing-in information into the memory cells ($Q_c$), a second bit address decoder (10) for decoding the bit address signals from the bit address buffer (8) for reading-out information from the memory cells ($Q_c$), a program circuit (20) for initially writing-in information to selected memory cells ($Q_c$), and a multiplexer (14) for reading-out information from selected memory cells ($Q_c$) characterised by at least one of the first (12) and second (10) bit address decoders being formed by a plurality of AND gates each consisting of a plurality of vertical PNP type transistors having their bases connected to the bit address buffer (8) to receive the address signals ($A_6$ to $A_9$) having their collectors commonly connected to the ground, and having their emitters commonly connected to an output terminal.

2. A device according to claim 1, in which the bit address signals are supplied to the first (12) and second (10) bit address decoders from a common bit address buffer ($BB_6$).

3. A device according to claim 2, in which the common bit address buffer ($BB_6$) is formed by a plurality of series connections of two inverters ($INV_1$ to $INV_4$).

4. A device according to any one of the preceding claims, in which the bit address signals are supplied to the first and second bit address decoders through address signal lines (26).

5. A device according to any one of the preceding claims, in which output terminals of the first bit address decoder (12) are connected to input terminals of the program circuit (20).

6. A device according to any one of the preceding claims, in which the output terminals of the second bit address decoder (10) are connected to input terminals of the multiplexer (14).

**Revendications**

1. Dispositif de mémoire morte bipolaire programmable comportant un certain nombre de cellules de mémoire ($Q_c$) qui sont placées aux points de croisement d'un certain nombre de lignes de mots ($W_i$) et d'un certain nombre de lignes de bits ($B_i$), chacune des cellules de mémoire étant constituée d'un transistor du type à base ouverte ($Q_c$) connecté entre une du nombre de lignes de bits ($B_i$) et une du nombre de lignes de mots ($W_i$), les cellules étant sélec-

tionnées par des signaux d'adresse de mot ($A_0$ à $A_5$) et par des signaux d'adresse de bit ($A_6$ à $A_9$) appliqués au dispositif, le dispositif comprenant un tampon d'adresse de mot (4) pour amplifier les signaux d'adresse de mot, un décodeur d'adresse de mot (6) pour décoder les signaux d'adresse de mot provenant du tampon d'adresse de mot, un ou plusieurs tampons d'adresse de bit (8) pour amplifier les signaux d'adresse de bit, un premier décodeur d'adresse de bit (12) pour décoder les signaux d'adresse de bit provenant du tampon d'adresse de bit pour écrire des informations dans les cellules de mémoire ($Q_c$), un second décodeur d'adresse de bit (10) pour décoder les signaux d'adresse de bit provenant du tampon d'adresse de bit (8) pour lire des informations dans les cellules de mémoire ($Q_c$), un circuit de programme (20) pour écrire initialement des informations dans des cellules de mémoire ($Q_c$) sélectionnées, et un multiplexeur (14) pour lire des informations dans les cellules de mémoire ($Q_c$) sélectionnées, caractérisé en ce qu'au moins un des premier (12) et second (10) décodeurs d'adresse de bit est constitué d'un ensemble de portes ET composées chacune d'un ensemble de transistors de type PNP verticaux dont les bases sont connectées au tampon d'adresse de bit (8) pour recevoir les signaux d'adresse ($A_6$ à $A_9$), dont les collecteurs sont connectés en commun à la masse, et dont les émetteurs sont connectés en commune à une borne de sortie.

2. Dispositif selon la revendication 1, caractérisé en ce que les signaux d'adresse de bit sont fournis aux premier (12) et second (10) décodeurs d'adresse de bit par un tampon d'adresse de bit ($BB_6$) commun.

3. Dispositif selon la revendication 2, caractérisé en ce que le tampon d'adresse de bit ($BB_6$) commun est constitué d'un ensemble de connexions en série de deux inverseurs ($INV_1$ à $INV_4$).

4. Dispositif selon l'une quelconque des revendications 1 à 3, caractérisé en ce que les signaux d'adresse de bit sont fournis aux premier et second décodeurs d'adresse de bit par l'intermédiaire de lignes de signaux d'adresse (26).

5. Dispositif selon l'une quelconque des revendications 1 à 4, caractérisé en ce que les bornes de sortie du premier décodeur d'adresse de bit (12) sont connectées à des bornes d'entrée du circuit de programme (20).

6. Dispositif selon l'une quelconque des revendications 1 à 5, caractérisé en ce que les bornes de sortie du second décodeur d'adresse de bit (10) sont connectéessà des bornes d'entrée du multiplexeur (14).

**Patentansprüche**

1. Bipolare programmierbare Festwertspeichervorrichtung mit einer Anzahl von Speicherzellen ($Q_c$), die an Kreuzungspunkten einer Anzahl von Wortleitungen ($W_i$) und einer Anzahl von Bitleitungen ($B_i$) angeordnet sind, bei welcher die Speicherzellen aus einem Transistor ($Q_c$) mit offener Basis bestehen und zwischen einer der Anzahl von Bitleitungen ($B_i$) und einer der Anzahl von Wortleitungen ($W_i$) angeschlossen sind und die Zellen durch Wortadressensignale ($A_0$ bis $A_5$) und durch Bitadressensignale ($A_6$ bis $A_6$) ausgewählt werden, die der Vorrichtung zugeführt werden, mit einem Wortadressenpuffer (4) zur Verstärkung der Wortadressensignale, einem Wortadressendecoder (6) zur Decodierung der Wortadressensignale von dem Wortadressenpuffer, einem oder mehreren Bitadressenpuffern (8) zur Verstärkung der Bitadressensignale, einem ersten Bitadressendecoder (12) zum Decodieren der Bitaddressensignale von dem Bitadressenpuffer zum Einschreiben von Information in die Speicherzellen ($Q_c$), einem zweiten Bitadressendecoder (10) zum Decodieren der Bitaddressensignale von dem Bitadressenpuffer (8) zum Auslesen von Information aus den Speicherzellen ($Q_c$), einer Programmschaltung (20) zum anfänglichen Einschreiben von Information in ausgewählte Speicherzellen ($Q_c$), und einem Multiplexer (14) zum Auslesen von Information aus den ausgewählten Speicherzellen ($Q_c$), dadurch gekennzeichnet, daß wenigstens der erste (12) und der zweite (10) Bitadressendecoder durch eine Anzahl von UND-Schaltungen gebildet sind, die jeweils aus einer Anzahl von vertikalen PNP-Typ-Transistoren bestehen, deren Basen mit dem Bitadressenpuffer (8) verbunden sind, um die Adressensignale ($A_6$ bis $A_9$) zu empfangen, deren Kollektoren gemeinsam mit Masse verbunden sind und deren Emitter gemeinsam mit einem Ausgangsanschluß verbunden sind.

2. Vorrichtung nach Anspruch 1, bei welcher die Bitadressensignale den ersten (12) und zweiten (10) Bitadressendecodern von einem gemeinsamen Bitadressenpuffer ($BB_6$) zugeführt werden.

3. Vorrichtung nach Anspruch 2, bei welcher der gemeinsame Bitadressenpuffer ($BB_6$) durch eine Anzahl von Reihenschaltungen von zwei Invertern ($INV_1$ bis $INV_4$) gebildet ist.

4. Vorrichtung nach einem der vorhergehenden Ansprüche, bei welcher die Bitadressensignale den ersten und zweiten Bitadressendecodern über Adressensignalleitungen (26) zugeführt werden.

5. Vorrichtung nach einem der vorhergehenden Ansprüche, bei welcher Ausgangsanschlüsse des ersten Bitadressendecoders (12) mit Eingangsanslüssen der Programmschaltung (20) verbunden sind.

6. Vorrichtung nach einem der vorhergehenden Ansprüche, bei welcher die Ausgangsanschlüsse des zweiten Bitadressendecoders (10) mit Eingangsanschlüssen des Multiplexers (14) verbunden sind.

# Fig. I

# Fig. 2

0 018 192

Fig. 3

0 018 192

# Fig. 4

Fig. 5

# Fig. 6

# Fig. 7

PROGRAM CIRCUIT

$V_{CC}$, $R_{74}$, $Q_{717}$, $D_{73}$, $Q_{718}$, $R_{73}$, $Q_{716}$, $R_{75}$, $R_{72}$, $D_{72}$, $R_{71}$, $R_{715}$, $Q_{715}$, $D_{71}$, $INV_5$, $\overline{CE}$, $D_{715}$, $R_{700}$, $Q_{700}$, $D_{700}$, $T_{415}$, $T_{400}$, $T_{200}$, $T_{215}$, $T_5$, 16, 14

# Fig. 8